Europäisches Patentamt

European Patent Office

Office européen des brevets

(19)

(11) Numéro de publication: **0 334 703**
A1

## (12) DEMANDE DE BREVET EUROPEEN

(21) Numéro de dépôt: **89400634.5**

(22) Date de dépôt: **07.03.89**

(51) Int. Cl.⁴: **H 03 H 7/32**

(30) Priorité: **15.03.88 FR 8803319**

(43) Date de publication de la demande:
**27.09.89 Bulletin 89/39**

(84) Etats contractants désignés: **DE FR**

(71) Demandeur: **COMPAGNIE EUROPEENNE DE COMPOSANTS ELECTRONIQUES LCC**
**50, rue Jean-Pierre Timbaud**
**F-92400 Courbevoie (FR)**

(72) Inventeur: **Grandjean, Daniel**
**SCPI 51, Esplanade du Général de Gaulle Cedex 67**
**F-92045 Paris La Défense (FR)**

**Seurre, Jean-Michel**
**SCPI 51, Esplanade du Général de Gaulle Cedex 67**
**F-92045 Paris La Défense (FR)**

**Zastko, Didier**
**SCPI 51, Esplanade du Général de Gaulle Cedex 67**
**F-92045 Paris La Défense (FR)**

(74) Mandataire: **Guérin, Michel et al**
**THOMSON-CSF SCPI 51, Esplanade du Général de Gaulle**
**F-92045 PARIS LA DEFENSE CEDEX 67 (FR)**

(54) **Ligne à retard électromagnétique comportant plusieurs sections cascadées.**

(57) L'invention concerne les lignes à retard électromagnétiques du type à constantes localisées et constituées d'une cascade de cellules dérivées en m. Les selfs de la ligne à retard sont disposées selon un ligne repliée (32), les selfs de deux cellules consécutives étant séparées d'une distance déterminée pour obtenir le paramètre m désiré, deux selfs non voisines étant séparées d'une distance suffisante pour rendre leur couplage négligeable.

FIG_8

EP 0 334 703 A1

## Description

## LIGNE A RETARD ELECTROMAGNETIQUE COMPORTANT PLUSIEURS SECTIONS CASCADEES

La présente invention se rapporte aux lignes à retard électromagnétiques du type à constantes localisées.

Les lignes à retard électromagnétiques sont des quadripôles dont le but est de retarder d'un temps constant les signaux appliqués à leur entrée. Elles sont réalisées en connectant en série plusieurs cellules élémentaires comportant une constante selfique et une constante capacitive. Dans le cas des lignes à retard électromagnétiques à constantes localisées, ces constantes sont celles de composants discrets (inductances et condensateurs) connectés entre eux de différentes manières (cellule à K constant, cellule dérivée en m, cellule passe-tout, ...etc). Le choix du type de cellule utilisé est dicté par les performances à obtenir et par la facilité et le coût de fabrication.

Les caractéristiques idéales attendues d'une ligne à retard comprennent un affaiblissement constant en fonction de la fréquence du signal injecté et minimal, un temps de propagation constant en fonction de la fréquence et un déphasage constant toujours en fonction de la fréquence.

La cellule dite à K constant ne pourra être utilisée que dans une gamme de fréquences très inférieure à la fréquence de coupure du quadripôle constituant la cellule, soit pratiquement jusqu'à une fréquence égale à 0,15 fois la fréquence de coupure si l'on désire conserver un retard constant à 1 % près.

A partir de la cellule à K constant, on peut définir deux sortes de cellules dérivées dites cellules dérivées en m: cellule dérivée série et cellule dérivée parallèle.

Une cellule dérivée en m a l'avantage, par rapport à une cellule à K constant, de présenter une faible variation du retard en fonction de la fréquence pour les valeurs de m voisines de 1,275. Pour cette valeur, le retard reste constant à 1 % près jusqu'à une fréquence égale à 0,55 fois la fréquence de coupure. Ceci permet d'utiliser la cellule dérivée en m sur une plage de fréquence 3,6 fois plus large que dans le cas de la cellule à K constant. L'impédance caractéristique présente pour les valeurs de m voisines de 0,6 une variation relative inférieure à 5 % dans la bande de fréquence allant de 0 à 0,85 fois la fréquence de coupure.

La cellule en m permet ainsi d'obtenir deux résultats importants : la régularisation de la courbe de retard (pour m = 1,275) et la régularisation de la courbe d'impédance caractéristique (pour m = 0,6). Pour disposer d'une ligne à retard possédant ces deux caractéristiques, on associera en cascade des cellules dérivées en m = 1,275 avec aux extrémités de la cascade deux demi-cellules en m = 0,6.

On connaît plusieurs manières de réaliser de telles lignes à retard. Ces lignes à retard se différencient par la façon de réaliser le bobinage des selfs.

Les selfs peuvent être bobinées sous la forme d'un solénoïde sur un barreau cylindrique. Toutefois, cela peut conduire dans certains cas (cas d'une faible ou d'une forte valeur d'inductance) à des dimensions de bobinage inacceptables ou à une valeur résistive de l'inductance trop élevée. Un remède à ceci consiste à effectuer le bobinage sur un support magnétique comportant des gorges destinées à recevoir les enroulements. On parvient généralement au but recherché, mais le bobinage reste malaisé et coûteux. On peut aussi faire appel à des supports magnétiques séparés (tores, barreaux, poulies), écartés suffisamment entre eux pour éviter une mutuelle inductance et bobinés chacun avec une prise intermédiaire. Ce mode de réalisation a l'avantage d'accorder au concepteur une complète liberté de la disposition géométrique des bobinages. Toutefois, la fabrication des inductances est très délicate et coûteuse. Par ailleurs, la disposition en série de bobinages couplés entre eux pose le problème de l'encombrement de la ligne à retard ainsi réalisée lorsque leur nombre est important. Le composant ainsi obtenu est trop long et inutilement trop étroit. Son implantation sur une carte imprimée devient impossible. On préfère alors disposer les bobinages sur deux barreaux magnétiques parallèles pour réduire l'encombrement longitudinal. La ligne à retard électromagnétique peut alors être livrée dans un boîtier DIL ( Dual In Line). L'encombrement total n'est pas excessif et le brochage utilisé (DIL 16 par exemple) est universel. Cependant, le passage d'un barreau magnétique à l'autre barreau magnétique provoque une rupture de couplage. Il s'ensuit que la ligne à retard électromagnétique ainsi constituée est en fait un ensemble de deux sections de lignes à retard cascadées sans précaution particulière. Cette connexion en série de deux lignes à retard électromagnétiques, par ailleurs performantes lorsqu'elles sont utilisées seules, présente les inconvénients suivants : rupture d'impédance à la liaison entre deux sections provoquant des réflexions parasites et des distorsions, ondulation de la courbe de retard, inégalités des pas de retards intermédiaires.

Les défauts précédemment signalés concernant la mise en série des lignes à retard électromagnétiques comportant plusieurs sections se recontrent à chaque fois que l'on tente de cascader plusieurs lignes à retard électromagnétiques individuellement performantes. Si ces défauts peuvent être tolérés dans de nombreux cas d'utilisation courante, ils sont rigoureusement inadmissibles pour des applications spécifiques où la régularité des réponses amplitude-fréquence, retard-fréquence, impédance-fréquence est indispensable (échographie médicale par exemple).

Afin de pallier ces inconvénients, l'invention propose une ligne à retard électromagnétique à constantes localisées utilisant des cellules du type dérivé en m et réalisées sous la forme de plusieurs sections cascadées sans discontinuité de couplage entre cellules. Les lignes à retard selon l'invention peuvent être élaborées sur un circuit imprimé ou sur tout autre substrat sans discontinuité de couplage entre les cellules internes à une même ligne à retard, ni discontinuité de couplage avec les cellules d'extrémités d'entrée et de sortie de la ligne.

L'invention a donc pour objet une ligne à retard électromagnétique du type à constantes localisées, constituée d'une cascade de cellules dérivées en m, les cellules comprenant des condensateurs et des selfs, caractérisée en ce que les selfs sont disposées selon une ligne repliée , les selfs de deux cellules consécutives étant séparées d'une distance déterminée pour obtenir le paramètre m désiré, deux selfs non voisines étant séparées d'une distance suffisante pour rendre leur couplage négligeable.

L'invention sera mieux comprise et d'autres avantages apparaîtront à la lecture de la description qui va suivre, donnée à titre non limitatif, et grâce aux dessins annexés parmi lesquels :

- la Figure 1 est un schéma électrique de ligne à retard électromagnétique selon l'art connu,
- la Figure 2 illustre une disposition classique de ligne à retard électromagnétique en boîtier DIL 16,
- la Figure 3 représente un support de bobinage,
- la Figure 4 est une figure explicative se rapportant à la façon d'effectuer les bobinages,
- les Figures 5, 6 et 7 illustrent des dispositions à adopter pour disposer les selfs d'une ligne à retard électromagnétique selon l'invention,
- les Figures 8 et 9 sont des vues de dessus et de dessous d'une section de ligne à retard selon l'invention,
- la Figure 10 illustre une manière de réaliser automatiquement le bobinage des selfs d'une ligne à retard selon l'invention.

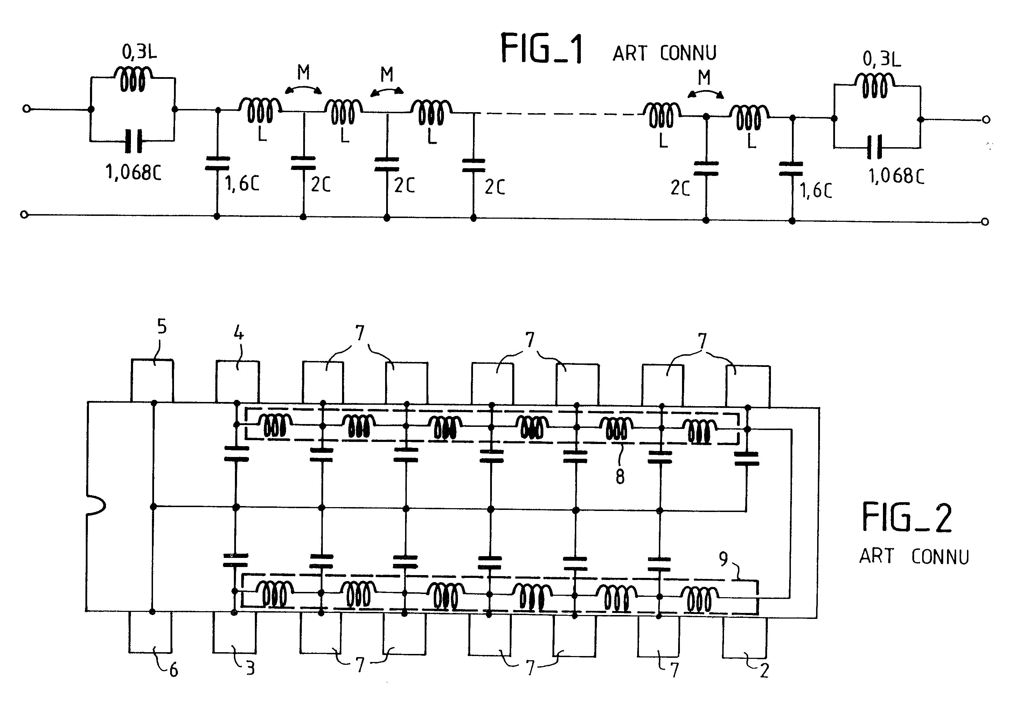

La Figure 1 est un schéma de ligne à retard électromagnétique selon l'art connu et utilisant des cellules du type dérivé en m. Elle comprend un nombre n de cellules en $\pi$.

La ligne à retard correspondant aux n cellules comprend n inductances L couplées deux à deux consécutivement et $n+1$ condensateurs. Les condensateurs placés entre deux inductances couplées ont une valeur 2C. Des prises de retard intermédiaires peuvent être aménagées à la sortie de chaque cellule. Chacune des inductances L est couplée à la suivante selon le degré de couplage désiré, par exemple $k = 11,9\,\%$ pour obtenir $m = 1,275$. Pour réaliser les deux demi-cellules d'extrémité en $m = 0,6$ destinées à régulariser la courbe impédance caractéristique en fonction de la fréquence, on effectue le montage indiqué d'une inductance de valeur 0,3 L et d'un condensateur de valeur 1,068 C placé en parallèle sur cette inductance. Les inductances de ces deux demi-cellules ne doivent pas être couplées aux inductances adjacentes. Les condensateurs des cellules d'interface entre les demi-cellules d'extrémités et les cellules en $\pi$ adjacentes doivent avoir une valeur de 1,6 C. Comme il a été dit plus haut, les inductances peuvent être bobinées sous la forme d'un solénoïde sur un barreau cylindrique en matière amagnétique, par exemple en verre.

La Figure 2 représente une disposition très classique de ligne à retard électromagnétique en boîtier DIL 16 mettant en oeuvre douze cellules. Le boîtier 1, en résine époxy moulé par transfert par exemple, comporte seize connexions externes telles que celle représentée sous la référence 2. Elles sont reliées intérieurement à douze cellules disposées parallèlement aux douze rangées de connexions. L'entrée de la ligne à retard électromagnétique est accessible par la connexion 3. Sa sortie principale correspond à la connexion 4. La masse commune est accessible par les connexions 5 et 6. Des prises intermédiaires correspondent aux connexions 7. Cette configuration très connue permet de réaliser une ligne à retard électromagnétique utilisant des cellules de type dérivé en m. Les selfs sont bobinées sur deux barreaux 8 et 9 représentés symboliquement en traits interrompus. Le principal inconvénient de cette ligne à retard est constitué par le point de liaison entre la sixième et la septième cellule, lorsque le fil de bobinage quitte un barreau pour s'enrouler sur l'autre. Le couplage magnétique, selon le coefficient de couplage $k = 11,9\,\%$ requis, n'est plus assuré. Il s'ensuit que la ligne à retard électromagnétique ainsi constituée est en fait un ensemble de deux sections de lignes à retard cascadées sans précaution particulière.

L'invention permet de réaliser des lignes à retard électromagnétiques dont les cellules sont mises en cascade, par exemple sur une carte de circuit imprimé, sans discontinuité de couplage entre les cellules internes à une même ligne à retard, ni discontinuité de couplage avec les demi-cellules d'extrémités.

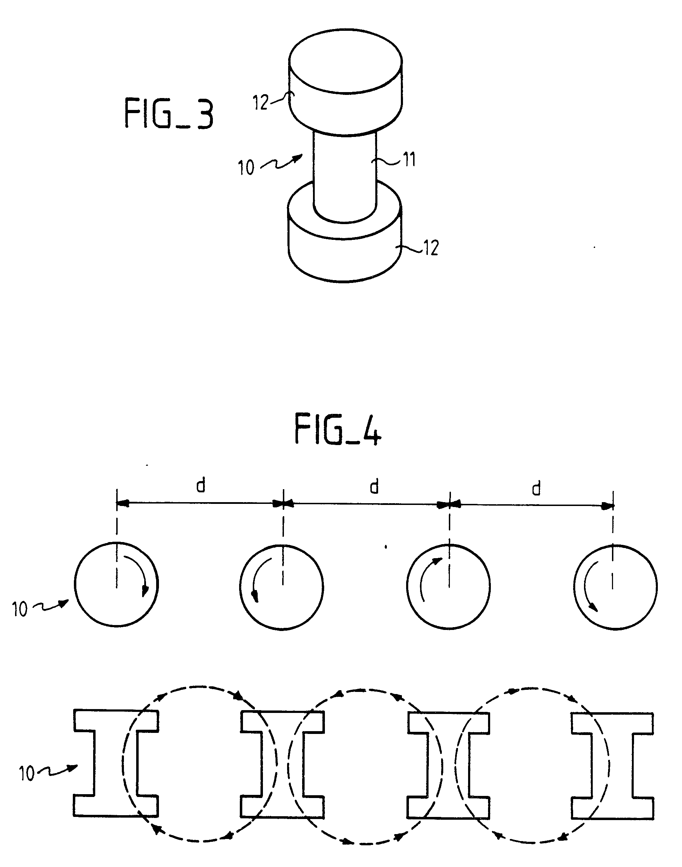

Dans un mode de réalisation préférentiel de l'invention, on fait appel à des supports de bobinage, de préférence en matériau magnétique. La Figure 3 représente un support de bobinage 10 ayant une forme de poulie. Cette poulie, représentée avec une section circulaire, peut aussi avoir d'autres formes : section carrée, rectangulaire, hexagonale, etc... Elle comporte une gorge 11 dans laquelle s'effectuera le bobinage entre les deux flasques 12.

La Figure 4 représente une rangée de poulies 10, selon des vues de face et de dessus, et ayant entre elles un entraxe $\underline{d}$ prédéterminé et constant. Le signe du coefficient de couplage k entre deux bobines dépend du sens de bobinage. Pour obtenir un couplage positif, on bobinera de la manière illustrée par la Figure 4 où l'on indique dans quel sens doit être bobiné le fil pour que les lignes de force des champs magnétiques aient la configuration représentée en traits interrompus. On constate qu'il faut alterner le sens des enroulements lorsqu'on passe d'un bobinage au suivant. La valeur du coefficient de couplage k (11,9 % par exemple) peut être obtenue expérimentalement par mesure de la self équivalente à deux bobinages couplés. On détermine ainsi quelle doit être la distance $\underline{d}$ séparant deux bobinages consécutifs.

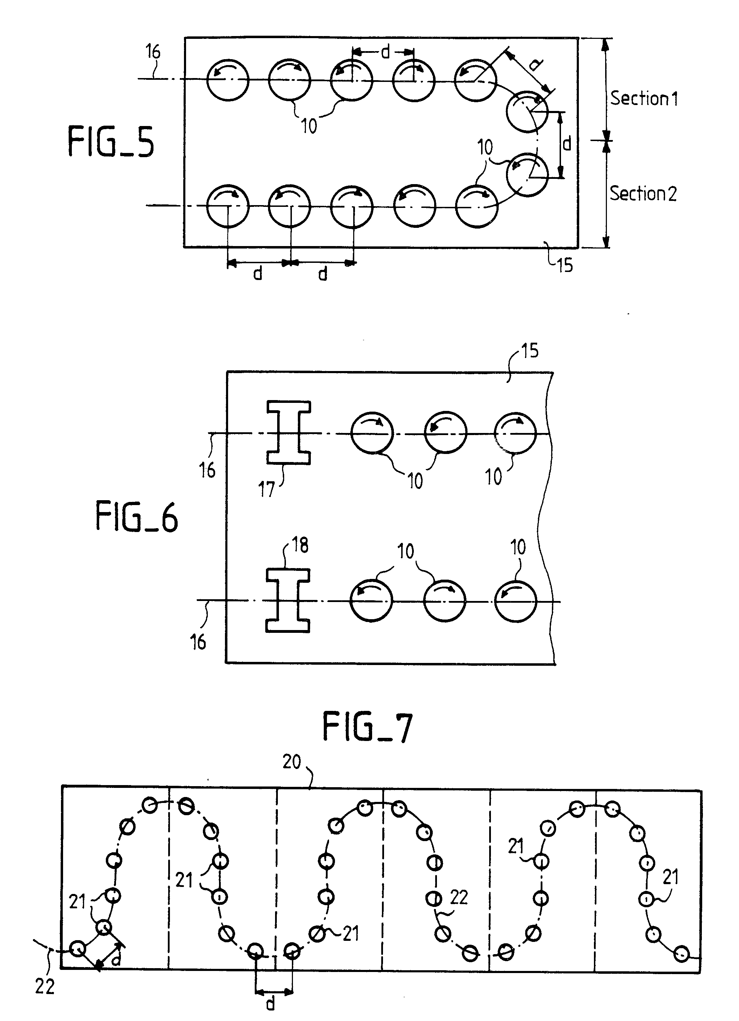

La distance $\underline{d}$ une fois connue, il suffit de fixer les bobinages selon les intervalles requis. La Figure 5 représente, vu de dessus, un support isolant ou un substrat (circuit imprimé, alumine) 15 sur lequel on a disposé des poulies de bobinage 10. Les poulies sont placées selon une ligne 16, tracée en trait mixte, deux poulies consécutives sur la ligne 16 étant séparées de la distance d. On remarque que, dans ce cas particulier, la ligne 16 a la forme d'un U couché. Les poulies situées à la base du U permettent d'assurer la continuité du couplage tout au long de la ligne à retard.

Si on compare les Figures 2 (selon l'art connu) et 5 (selon l'invention), on peut considérer qu'il existe deux sections sur ces dispositifs. D'après la Figure 2, une section est déterminée par un barreau 8 ou 9 et il y a donc pour ce dispositifs deux sections avec rupture de couplage entre ces sections. D'après la Figure 5, la future ligne à retard comprendra également deux sections, chaque section étant une branche du U mais, dans ce cas, il n'y a pas de rupture de couplage.

Il est avantageux de placer à l'entrée et à la sortie de la ligne à retard deux demi-cellules en m = 0,6 destinées à régulariser la courbe impédance-fréquence. Pour ce faire, on peut écarter les poulies de ces demi-cellules adjacentes de manière à les découpler. On peut également les coucher sur le substrat de manière à orienter leurs champs magnétiques à 90° par rapport à ceux des autres cellules comme cela est représenté sur la Figure 6. Sur cette figure, où les mêmes références qu'à la Figure 5 représentent les mêmes éléments, les poulies 17 et 18 destinées à recevoir les enroulements des selfs des cellules d'entrée et de sortie sont couchées sur le substrat 15.

Les Figures 5 et 6 se rapportent à une ligne à retard devant comporter douze cellules dérivées en m et formée de deux sections de six cellules cascadées sans discontinuité du degré de couplage entre l'entrée et la sortie. L'invention peut être appliquée à un nombre indifférent de cellules. De même, les bobinages assurant la jonction de la base du U peuvent être en nombre quelconque mais au moins un est nécessaire. En effet, deux rangées de bobinages espacées seulement d'une distance égale à d présenteraient des couplages parasites indésirables et nuisibles au fonctionnement. Le nombre de sections ainsi couplées n'est pas limité.

La Figure 7 se rapporte à une ligne à retard électromagnétique selon l'invention. On n'a représenté sur cette Figure que le substrat 20 (vu de dessus) et les poulies 21 qui supporteront les bobinages. On peut délimiter le substrat en six sections (séparées par des traits interrompus sur la Figure) comportant chacune six cellules dérivées en m, soit 36 cellules couplées sans discontinuité de couplage Le substrat 20 peut être en une seule partie ou formé par l'association de six modules correspondant aux sections. D'autres combinaisons sont encore possibles (2 supports de 18 cellules, etc...). Le point essentiel est constitué par la disposition des poulies 21 le long d'une ligne imaginaire 22 représentée en trait mixte, les poulies se suivant sur cette ligne selon des intervalles d correspondant au couplage désiré. La ligne 22 a été imaginée pour satisfaire deux conditions : disposer un grand nombre de cellules dans un espace restreint, rendre négligeables les couplages entre deux selfs non voisines. Pour obtenir la ligne à retard, il faudra alors réaliser le bobinage des poulies, disposer les condensateurs et assurer les liaisons électriques.

Une fois le câblage entre les différents éléments de la ligne à retard (selfs, condensateurs, connexions d'entrée, de sortie, de masse, et éventuellement connexions de sorties intermédiaires) réalisé, le support 20 peut être placé dans un boîtier et moulé dans un matériau non magnétique (plastique, résine époxy) de manière à laisser s'exercer librement le couplage magnétique entre les cellules de liaison.

A titre d'exemple, on va décrire une méthode de réalisation et de câblage d'une ligne à retard électromagnétique selon l'invention. On considérera le cas où un même module supporte deux sections.

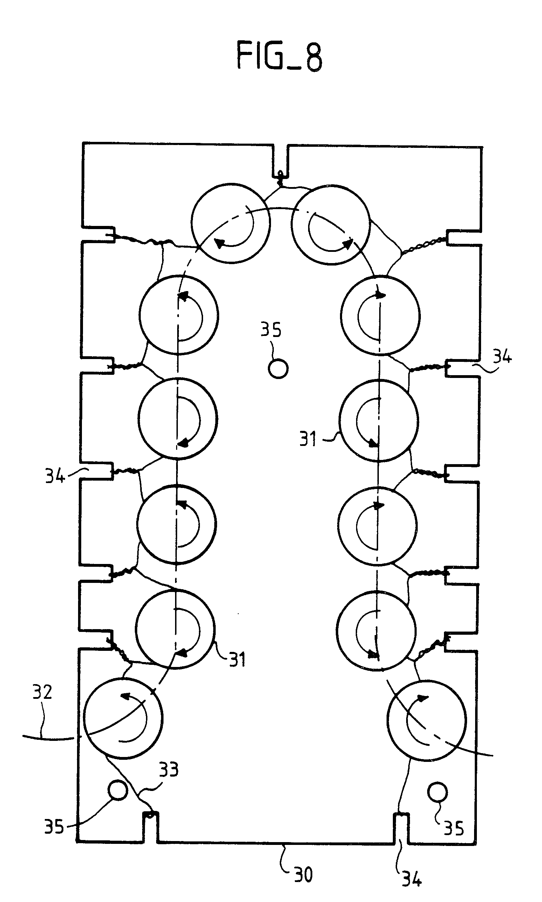

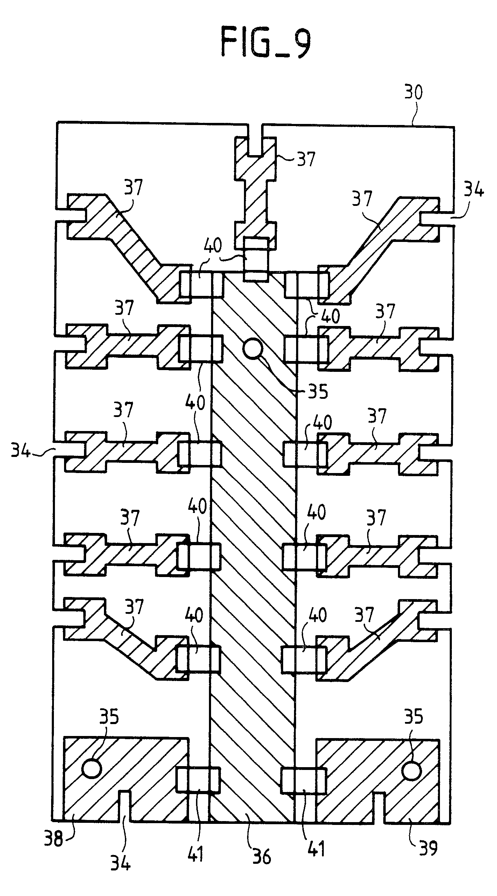

Les Figures 8 et 9 représentent des vues de dessus et de dessous d'un tel module. Sur une face d'un substrat 30 (voir la Figure 8) , on a fixé des poulies 31 destinées à supporter les bobinages. Ces poulies sont disposées le long d'une ligne 32 représentée en trait mixte et reprenant le motif de la Figure 7. Un fil conducteur émaillé 33 est bobiné sur les poulies 31 tantôt dans un sens, tantôt dans l'autre sens, comme le montrent les flèches dessinées sur les bobines. Entre chaque poulie, le fil est ramené sur l'autre face du substrat pour y être soudé et disposer ainsi d'une prise de contact électrique. Des encoches 34 sont disposées à la périphérie du substrat 30 pour faciliter le report du fil 33 sur l'autre face. Le substrat est également percé de trois trous 35 qui permettront le passage de broches destinées à assurer les liaisons électriques (entrée, sortie, masse). Sur l'autre face du substrat 30 (voir la Figure 9), les zones hachurées représentent des métallisations. La métallisation 36 est une métallisation de masse. Les métallisations 37, 38 et 39 assureront les liaisons électroniques entre les bobinages (le fil 33 est périodiquement soudé sur ces métallisations) et les condensateurs 40 et 41. Dans l'exemple choisi, les condensateurs 41 peuvent avoir une valeur moitié de celle des condensateurs 40 selon la disposition du module dans l'ensemble des modules (module d'extrémité ou module intermédiaire). En effet, dans certains cas, deux condensateurs 41 peuvent se trouver en parallèle et alors leur valeur s'ajoute. Les métallisations 38 et 39 devront en outre assurer les liaisons d'entrée et de sortie du module. Sur la Figure 9, le fil de bobinage (référence 33 sur la Figure 8) n'a pas été représenté. En fait, il est reporté par les encoches 34, et soudé périodiquement sur les métallisations 37, 38 et 39.

La fixation des poulies sur leur substrat peut se faire par collage. On peut déposer un point de colle (résine époxy-époxy polymérisable UV, cyanoacrylate) sur le substrat à l'aide d'un pochoir, d'un écran de sérigraphie ou préférentiellement d'une machine de report automatique x, y, z de type "pick and place". Le même type de machine ou un gabarit muni de trous appropriés permet de déposer les poulies à leur place. Une polymérisation sous tunnel infra-rouge, étuve ou préférentiellement par rayonnement ultra-violet assure une fixation robuste des poulies sur le substrat.

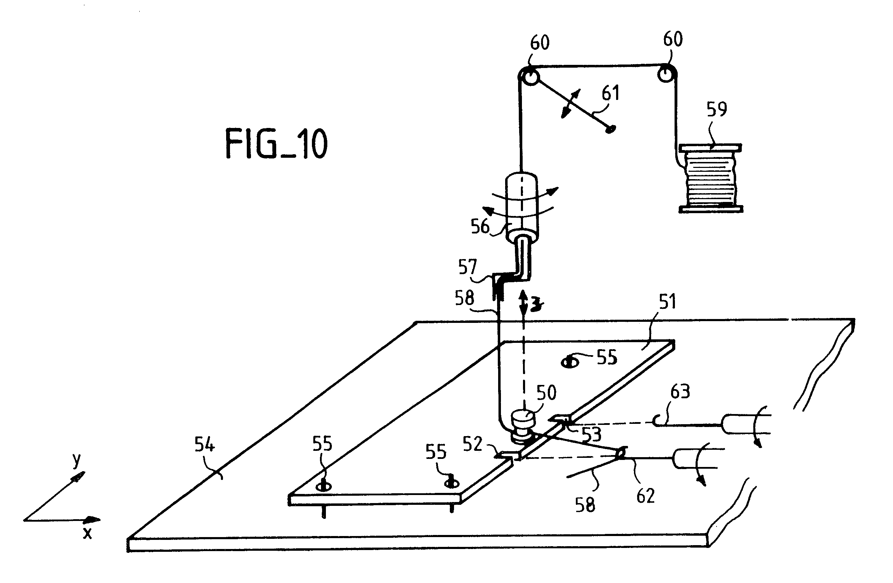

Pour réaliser le bobinage des poulies, le substrat peut être placé sur une table capable de se déplacer selon deux axes x, y et en fonction d'un programme numérique. La Figure 10 illustre cette manière de procéder. Pour simplifier le dessin, une seule poulie 50 a été représentée sur le sbustrat 51. Pour la même raison on n'a représenté que les deux encoches 52 et 53 qui sont de part et d'autre de la poulie 50. La table 54 comporte des pions de guidage 55 qui s'insèrent dans les trois trous de substrat déjà mentionnés et qui recevront ultérieurement des broches. Ainsi, la position des poulies par rapport à la tête de bobinage dite "FLYER" 56 est bien déterminée. La tête de bobinage 56 peut se déplacer dans la direction verticale z et tourner dans les deux sens autour de cet axe z. La tête de bobinage 56 comporte une partie 57 en forme de manivelle creuse dans laquelle glisse le fil de bobinage 58 issu d'une bobine 59. Le fil 58 est guidé par des poulies 60 et correctement tendu par un dispositif classique 61. Préalablement au bobinage, par un mouvement approprié de la table mobile 54 selon les directions x et y et de la tête de bobinage 56 selon la direction z, le fil est amené derrière le crochet 62 puis la table ramène l'axe de la poulie concernée à l'aplomb de la tête de bobinage 56 qui est mise en rotation dans le sens voulu pour réaliser le bobinage de cette poulie. Un certain nombre de tours sont exécutés. Le fil de bobinage 58 est ainsi enroulé autour de la poulie 50 avant d'être à nouveau passé derrière le crochet 63. Cette suite d'opérations est répétée pour les autres poulies.

A l'issue du programme de bobinage des poulies, les crochets tels 62 et 63 sont mis en rotation pour torsader les portions de fil que leur sont accrochées. Les crochets sont munis d'arêtes tranchantes qui sectionnent et libèrent les torsades de fil en fin d'opération.

Le substrat équipé de ses poulies bobinées est placé sur une machine de report de type "pick and place" qui permet la dépose de condensateurs de type chips (condensateurs 40 et 41 de la Figure 9) sur la face du substrat opposée à celle qui support les poulies. La machine assure la soudure des électrodes des condensateurs sur les métallisations du substrat. Les encoches disposées à la périphérie du substrat permettent de replier les torsades de fil vers la face métallisée du substrat. Ces torsades, après étamage au trempé par exemple, sont soudées sur les emplacements qui leur sont réservés.

Le fait d'élaborer une ligne à retard par association de sections identiques à l'avantage de pouvoir éliminer les sections défectueuses avant l'association. Il est moins coûteux de rejeter une section de 12 cellules défectueuses que d'éliminer pour la même raison un ensemble fini comportant 120 cellules. Cette possibilité de contrôle intermédiaire constitue un avantage important de l'invention par rapport à l'art antérieur.

L'assemblage et le positionnement relatif entre elles des sections ainsi réalisées et contrôlées sur un support principal peuvent être assurés par des clous ou broches de connexion dans les trous d'insertion (référencés 35 sur les Figures 8 et 9). Ces clous ou broches assurent, grâce à des points de soudure, une double fonction mécanique et électrique. Ils permettent l'accès à l'entrée et à la sortie de la ligne à retard, ainsi qu'à des prises de retards intermédiaires.

Avant moulage par coulée d'une résine époxy par exemple, un nouveau contrôle électrique peut être effectué. Une fois la coulée effectuée, la résine peut être polymérisée dans une étuve.

Il entre dans le cadre de la présente invention d'utiliser des selfs autres que celles qui sont obtenues par bobinage d'un fil sur un support. Des selfs obtenues par des métallisations déposées sur un substrat et réalisées par exemple par gravure conviendraient également pourvu que l'on respecte la distance prévue entre deux selfs successives et la distance minimale entre deux selfs non voisines.

Si l'on désire placer au début et à la fin de la ligne à retard deux demi-cellules en $m = 0,6$ pour régulariser la courbe de l'impédance caractéristique, on peut concevoir la ligne à retard selon le schéma de la Figure 1. Les demi-cellules peuvent être placées sur la première et sur la dernière section en utilisant la disposition décrite par la Figure 6.

## Revendications

1. Ligne à retard électromagnétique du type à constantes localisées, constituée d'une cascade de cellules dérivées en m, les cellules comprenant des condensateurs et des selfs, caractérisée en ce que les selfs sont disposées selon une ligne repliée (16, 22, 32), les selfs de deux cellules consécutives étant séparées d'une distance déterminée pour obtenir le paramètre m désiré, deux selfs non voisines étant séparées d'une distance suffisante pour rendre leur couplage négligeable.

2. Ligne à retard selon la revendication 1, caractérisée en ce que les selfs sont constituées par un fil (33) bobiné sur des supports (31).

3. Ligne à retard selon la revendication 2, caractérisée en ce que les supports (31) sont magnétiques.

4. Ligne à retard selon l'une des revendications 2 ou 3, caractérisée en ce que les supports ont une forme de poulie (10).

5. Ligne à retard selon la revendication 1, caractérisée en ce que les selfs sont constituées à partir de métallisations déposées sur un substrat.

6. Ligne à retard selon l'une quelconque des revendications 1 à 5, caractérisée en ce que le paramètre m vaut 1,275.

7. Ligne à retard selon l'une quelconque des revendications 1 à 6, caractérisée en ce qu'elle comprend en outre au moins une cellule d'extrémité destinée à régulariser la courbe d'impédance caractéristique, le couplage entre la self de la cellule d'extrémité et la self de la cellule voisine de la ligne à retard étant tel que $m = 0,6$.

8. Ligne à retard selon la revendication 7, caractérisée en ce que les selfs étant obtenues par bobinage d'un fil sur un support, le bobinage de la self de la cellule d'extrémité est orienté à 90° par rapport au bobinage de la self de la cellule voisine.

9. Ligne à retard selon la revendication 7, caractérisée en ce que le couplage entre la self de la cellule d'extrémité et la self de la cellule voisine est déterminée par la distance qui les sépare.

10. Ligne à retard selon l'une quelconque des revendications précédentes, caractérisée en ce qu'elle est réalisée sur un susbtrat (30) supportant les selfs sur l'une de ses faces et les condensateurs (40, 41) sur l'autre face.

FIG_1  ART CONNU

FIG_2
ART CONNU

EP 0 334 703 A1

FIG_3

FIG_4

FIG_5

Section 1

Section 2

FIG_6

FIG_7

## FIG_8

# FIG_9

FIG_10

EP 0 334 703 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | DE-A-3 607 927 (TOKO INC.) <br> * Page 7, ligne 16 - page 8, ligne 2; page 12, ligne 15 - page 13, ligne 3; page 18, ligne 4 - page 19, ligne 14; figures 1-7,16 * | 1-5,10 | H 03 H 7/32 |
| A | PATENT ABSTRACTS OF JAPAN, vol. 11, no. 119 (E-499)[2566], 14 avril 1987, page 142 E 499; & JP-A-61 267 405 (ELMEC CORP.) 27-11-1986 <br> * Résumé * | 1 | |
| A | PATENT ABSTRACTS OF JAPAN, vol. 1, no. 42 (E-76)[2565], 25 avril 1977, page 2565 E 76; & JP-A-51 139 234 (TOKO K.K.) 01-12-1976 <br> * Résumé * | 1-4 | |
| A | US-A-2 589 076 (HANCOCK et al.) <br> * Colonne 1, lignes 20-24; colonne 1, ligne 53 - colonne 2, ligne 47; figures 1,2 * | 1,9 | DOMAINES TECHNIQUES RECHERCHES (Int. Cl.4) |
| A | IRE TRANSACTIONS ON COMPONENT PARTS, vol. CP-4, no. 1, mars 1957, pages 24-28; D. ELDERS: "A novel construction concept for linear delay lines" <br> * Page 25, colonne de gauche, lignes 9-22; figure 3 * | 1-3,9 | H 03 H |

-/-

**Le présent rapport a été établi pour toutes les revendications**

| Lieu de la recherche | Date d'achèvement de la recherche | Examinateur |
|---|---|---|
| LA HAYE | 16-06-1989 | DEN OTTER A.M. |

EPO FORM 1503 03.82 (P0402)

Office européen
des brevets

**RAPPORT DE RECHERCHE EUROPEENNE**

Numero de la demande

EP 89 40 0634

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | NACHRICHTENTECHNISCHE ZEITSCHRIFT, vol. 18, no. 11, novembre 1965, pages 625-633; P. ALBRECHT: "Entwicklung und Aufbau einer kontinuierlich regelbaren Verzögerungsleitung für Videosignale" * Page 628, chapitres 4.2.2,4.2.3.; page 631, colonne de droite, chapitre 6.5; figures 11,12,19 * | 6-8 | |
| A | US-A-2 946 967 (ELDERS) * Colonne 2, lignes 6-21,63-67; colonne 4, lignes 8-13; colonne 5, lignes 25-30; figures 1,3 * | 8,9 | |

**DOMAINES TECHNIQUES RECHERCHES (Int. Cl.4)**

Le présent rapport a été établi pour toutes les revendications

| Lieu de la recherche | Date d'achèvement de la recherche | Examinateur |
|---|---|---|
| LA HAYE | 16-06-1989 | DEN OTTER A.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)